# EUROPEAN PATENT APPLICATION

(11) **EP 4 773 256 A1**
(43) Date of publication of application: **08.07.2026**
(21) Application number: 25770924.6
(22) Date of filing: 21.05.2025
(51) Int. Cl.: H01M 4/66, H01M 4/13, H01M 10/0525

(54) **SEMICONDUCTOR STRUCTURE AND MANUFACTURING METHOD THEREFOR**

(30) Priority: 16.08.2024 CN 202411133716
(71) Applicant: CXMT Corporation, Hefei City, Anhui Province 230601 (CN)
(72) Inventor: LIANG, Zhiwei, Hefei, Anhui 230601 (CN)
(74) Representative: Gulde & Partner
(86) International application number: PCT/CN2025/096162
(87) International publication number: WO 2026/036829

(57) **Abstract**

The present disclosure provides a semiconductor structure and a method for manufacturing the same. The semiconductor structure at least includes: an underlying conductive layer and a blocking portion, a plane in which the blocking portion is located being located above a plane in which the underlying conductive layer is located, and projections of the blocking portion and the underlying conductive layer in the vertical direction having an overlapping region; a three-dimensional structure, the three-dimensional structure including a first portion and a second portion, a top surface of the blocking portion being higher than a bottom surface of the second portion and being lower than or flush with a bottom surface of the first portion, and at least a part of the first portion being located directly above the overlapping region; a contact hole and a first conductive layer, a plane in which the first conductive layer is located being higher than a top surface of the three-dimensional structure, the contact hole being directly connected to the first conductive layer, the underlying conductive layer being electrically connected to the first conductive layer through the contact hole, and the contact hole being located on a side of the first portion away from the second portion; and a first isolation layer, the first isolation layer being configured to fill a region between the contact hole and the three-dimensional structure and a region between different contact holes.

## Description

### CROSS-REFERENCE TO RELATED APPLICATIONS

This application is based on and claims priority to Chinese Patent Application No. 202411133716.9, filed with China National Intellectual Property Administration on August 16, 2024 and entitled "SEMICONDUCTOR STRUCTURE AND METHOD FOR MANUFACTURING SAME". The above-referenced application is incorporated herein by reference in its entirety.

### TECHNICAL FIELD

Embodiments of this application relate to the semiconductor field, and in particular, to a semiconductor structure and a method for manufacturing the same.

### BACKGROUND

In a procedure of manufacturing a semiconductor structure, a film layer with a specific shape needs to be formed by means of deposition and etching. However, a specific effect of material deposition and etching is related to a morphology of a target structure. For example, when a material is deposited to fill a groove with a large depth-to-width ratio, a hollow gap tends to form. When an actual effect of material deposition or etching deviates from an expected effect, actual performance of a final structure may be affected.

### SUMMARY

Embodiments of this application provide a semiconductor structure and a method for manufacturing the same, which at least helps to solve the problem of signal crosstalk between contact holes.

According to some embodiments of this application, an aspect of the embodiments of this application provides a semiconductor structure, including: an underlying conductive layer and a blocking portion, a plane in which the blocking portion is located being located above a plane in which the underlying conductive layer is located, and projections of the blocking portion and the underlying conductive layer in the vertical direction having an overlapping region; a three-dimensional structure, the three-dimensional structure including a first portion and a second portion, a top surface of the blocking portion being higher than a bottom surface of the second portion and being lower than or flush with a bottom surface of the first portion, and at least a part of the first portion being located directly above the overlapping region; a contact hole and a first conductive layer, a plane in which the first conductive layer is located being higher than a top surface of the three-dimensional structure, the contact hole being directly connected to the first conductive layer, the underlying conductive layer being electrically connected to the first conductive layer through the contact hole, and the contact hole being located on a side of the first portion away from the second portion; and a first isolation layer, the first isolation layer being configured to fill a region between the contact hole and the three-dimensional structure and a region between different contact holes.

In some embodiments, the semiconductor structure further includes a second conductive layer. The blocking portion is a part of the second conductive layer, the underlying conductive layer is electrically connected to the second conductive layer through a first conductive plug, and the second conductive layer is electrically connected to the first conductive layer through the contact hole.

In some embodiments, the second conductive layer further includes a signal transmission portion. The signal transmission portion is separated from the blocking portion, the blocking portion is located between the signal transmission portion and the second portion, and the underlying conductive layer is electrically connected to the contact hole through the signal transmission portion.

In some embodiments, the vertical direction is perpendicular to a first horizontal direction, and the semiconductor structure further includes multiple contact holes arranged in the first horizontal direction and a blocking portion extending in the first horizontal direction; and each of the contact holes is electrically connected to the underlying conductive layer through a corresponding second signal line in the signal transmission portion, and the blocking portion is located between the second signal line corresponding to any of the contact holes and the second portion.

In some embodiments, the vertical direction is perpendicular to a first horizontal direction and a second horizontal direction, and the first horizontal direction is perpendicular to the second horizontal direction; the semiconductor structure further includes multiple contact holes arranged in the first horizontal direction, and the blocking portion includes multiple blocking blocks arranged in the first horizontal direction; and in a projection plane perpendicular to the vertical direction, the multiple contact holes and the multiple blocking blocks are disposed alternately in the first horizontal direction and staggered in the second horizontal direction.

In some embodiments, the second conductive layer includes multiple second signal lines. The underlying conductive layer transmits an electrical signal through the second signal lines and the contact hole, the second signal lines extend to below the at least a part of the first portion, and the blocking portion includes parts of the second signal lines extending to below the first portion.

In some embodiments, the second conductive layer further includes a redundant line. The redundant line is not provided with the contact hole, and the blocking portion further includes a part of the redundant line extending to below the first portion.

In some embodiments, the second conductive layer further includes a second fill line. The width of the second fill line is less than the width of the second signal line, the second fill line is configured to balance densities of conductive materials in different regions of the second conductive layer, and the blocking portion further includes a part of the second fill line extending to below the first portion.

In some embodiments, the blocking portion surrounds the three-dimensional structure.

In some embodiments, the three-dimensional structure is a capacitor electrode. The capacitor electrode includes a top electrode of a storage capacitor or a top electrode or a bottom electrode of a non-storage capacitor.

According to some embodiments of this application, another aspect of the embodiments of this application further provides a method for manufacturing a semiconductor structure, including: forming an underlying conductive layer and a blocking portion sequentially, a plane in which the blocking portion is located being located above a plane in which the underlying conductive layer is located, and projections of the blocking portion and the underlying conductive layer in the vertical direction having an overlapping region; forming a three-dimensional structure, the three-dimensional structure including a first portion and a second portion, a top surface of the blocking portion being higher than a bottom surface of the second portion and being lower than or flush with a bottom surface of the first portion, and at least a part of the first portion being located directly above the overlapping region; forming a first isolation layer, the first isolation layer being configured to fill a region above the underlying conductive layer and the blocking portion, a top surface of the first isolation layer being higher than a top surface of the three-dimensional structure, and the first isolation layer being located on a side of the first portion away from the second portion and covers a side wall of the first portion; and forming a contact hole and a first conductive layer, the contact hole running through the first isolation layer, and the first conductive layer being electrically connected to the underlying conductive layer through the contact hole.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings.
FIG. 1 is a front view of a semiconductor structure according to some embodiments of this application;
FIG. 2 is a top view of the semiconductor structure shown in FIG. 1;
FIG. 3 is a front view of a semiconductor structure;
FIG. 4 is a top view of the semiconductor structure shown in FIG. 3;
FIG. 5 is a front view of a semiconductor structure according to some embodiments of this application;
FIG. 6 is a front view of a semiconductor structure according to some embodiments of this application;
FIG. 7 is a top view corresponding to the semiconductor structure shown in FIG. 6 according to some embodiments of this application;
FIG. 8 is a top view corresponding to the semiconductor structure shown in FIG. 6 according to some other embodiments of this application;
FIG. 9 is a front view of a semiconductor structure;
FIG. 10 is a front view of a semiconductor structure according to some embodiments of this application;
FIG. 11 is a top view corresponding to the semiconductor structure shown in FIG. 10 according to some embodiments of this application;
FIG. 12 is a top view corresponding to the semiconductor structure shown in FIG. 10 according to some embodiments of this application; and
FIG. 13 is a top view of a semiconductor structure according to some embodiments of this application.

### DESCRIPTION OF EMBODIMENTS

Embodiments of this application are described in detail below with reference to the accompanying drawings. However, it may be understood by a person of ordinary skill in the art that in the embodiments of this application, many technical details are provided to enable readers to better understand this application. However, the technical solutions claimed in this application may be implemented even without these technical details and various changes and modifications made based on the following embodiments.

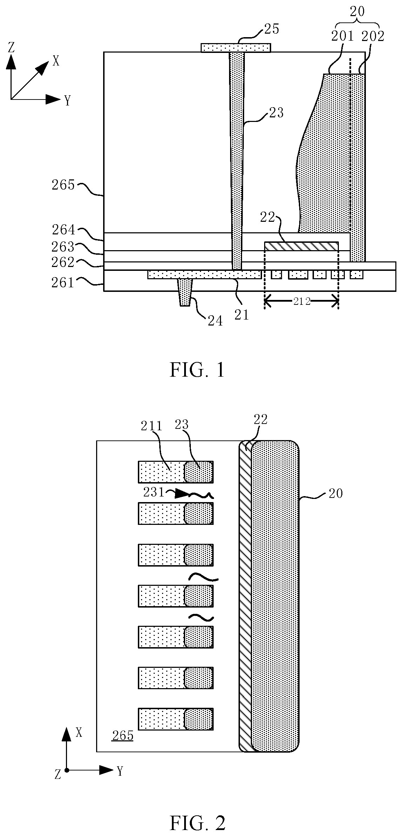

FIG. 1 is a front view of a semiconductor structure according to some embodiments of this application; and FIG. 2 is a top view of the semiconductor structure shown in FIG. 1. Referring to FIG. 1 and FIG. 2, a semiconductor structure includes: an underlying conductive layer 21 and a blocking portion 22, a plane in which the blocking portion 22 is located being located above a plane in which the underlying conductive layer 21 is located, and projections of the blocking portion 22 and the underlying conductive layer 21 in the vertical direction Z having an overlapping region 212; a three-dimensional structure 20, the three-dimensional structure 20 including a first portion 201 and a second portion 202, a top surface of the blocking portion 22 being higher than a bottom surface of the second portion 202 and being lower than or flush with a bottom surface of the first portion 201, and at least a part of the first portion 201 being located directly above the overlapping region 212; a contact hole 23 and a first conductive layer 25, a plane in which the first conductive layer 25 is located being higher than a top surface of the three-dimensional structure 20, the contact hole 23 being directly connected to the first conductive layer 25, the underlying conductive layer 21 being electrically connected to the first conductive layer 25 through the contact hole 23, and the contact hole 23 being located on a side of the first portion 201 away from the second portion 202; and a first isolation layer 265, the first isolation layer 265 being configured to fill a region between the contact hole 23 and the three-dimensional structure 20 and a region between different contact holes 23.

In the embodiments of this application, a blocking layer 22 is provided and at least a part of the three-dimensional structure 20 (that is, at least a part of the first portion 201) is located on the blocking layer 22, which helps to raise a bottom position of the at least a part of the three-dimensional structure 20, thereby reducing the height-to-width ratio of the part of the three-dimensional structure 20, preventing a recessed portion facing the second portion 202 from being formed on a side wall of the first portion 201 due to an excessively large height-to-width ratio, preventing a gap from being formed due to the presence of the recessed portion when the first isolation layer 265 performs filling and covers the side wall of the first portion 201, avoiding expansion and movement of a single gap and communication between different gaps, and avoiding signal crosstalk or even short circuit between different contact holes due to the presence of a gap.

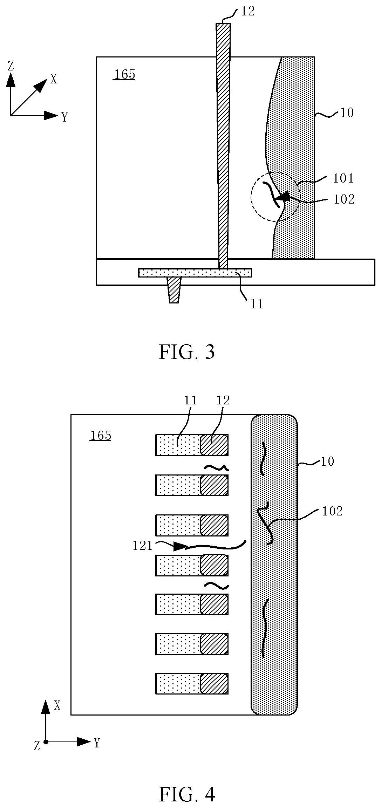

FIG. 3 is a front view of a semiconductor structure; and FIG. 4 is a top view of the semiconductor structure shown in FIG. 3. Referring to FIG. 3, in a case in which no blocking portion is provided, a recessed portion 101 is formed on a side wall of a three-dimensional structure 10 facing a contact hole 12 due to a large height-to-width ratio. The inventor of this application finds that the recessed portion 101 is generally present in a region adjacent to the bottom of the first portion 201. When an isolation material is deposited to form a first isolation layer 165, due to shielding of an upper structure of the recessed portion 101, a filling angle, and the like, it is difficult to fill the interior of the recessed portion 101, and a first gap 102 is likely to be formed. Furthermore, referring to FIG. 4, after the isolation layer 165 is formed, a via hole exposing an underlying conductive layer 11 is generally formed by etching, and then the via hole is filled to form the contact hole 12. However, the inventor of this application finds that, in the isolation layer 165, a gap may also be formed between different via holes, which is denoted as a second gap 121. Because the first gap 102 may be contiguous in a first horizontal direction 12, and both the first gap 102 and the second gap 121 may expand, a possibility that the via hole is communicated with one or both of the first gap 102 or the second gap 121 may occur. When a conductive material is deposited to form the contact hole 12, the first gap 102 and the second gap 121 may be filled with a part of the conductive material, which may cause crosstalk or even a short circuit between different contact holes 12 when an electrical signal is transmitted.

The embodiments of this application are described in more detail below with reference to the accompanying drawings.

Referring to FIG. 1, in some embodiments, the underlying conductive layer 21 is connected to the source, the drain, or the gate of a transistor located in an active region (not shown) through a second conductive plug 24, no other conductive layer is provided below a plane in which the underlying conductive layer 21 is located, and positions in which gates of different transistors are located do not meet a definition of a "conductive layer" in this application. A cross-sectional shape of the underlying conductive layer 21 is related to a cross-sectional position of a front view, and cross-sectional shapes of different cross-sectional positions may be different. Referring to FIG. 2, the underlying conductive layer 21 includes at least multiple underlying signal lines 211, and each of the underlying signal lines 211 is connected to a corresponding contact hole 23 for transmitting an electrical signal. Although the multiple underlying signal lines 211 shown in FIG. 2 are straight lines with the same length that are parallel to each other, actually, each of the underlying signal lines 211 may be different in length from an adjacent underlying signal line 211 or may be a bend line, and there is no parallel limitation between different underlying signal lines 211.

It should be noted that "planes" mentioned in this application, for example, the plane in which the blocking portion 22 is located and the plane in which the underlying conductive layer 21 is located, are all defined by using bottom surfaces of corresponding structures, that is, a plane in which a structure is located refers to a plane in which a bottom surface of the structure is located. In some embodiments, the definition of the "conductive layer" is that the conductive layer has a two-dimensional top surface and bottom surface, that is, top surfaces of the conductive layer at different positions are flush, and bottom surfaces of the conductive layer at different positions are flush. In addition, in the embodiments of this application, the top surface of the blocking portion 22 is not limited, and the top surface of the blocking portion 22 may be either a plane or a three-dimensional surface.

In some embodiments, a projection of the blocking portion 22 in the vertical direction Z is entirely located in a projection of the underlying conductive layer 21. A side edge of the blocking portion 22 facing the second portion 202 may fall within the projection of the underlying conductive layer 22, or may be flush with a side edge of the underlying conductive layer 21 close to the second portion 202. In some other embodiments, in the vertical direction Z, the projection of the blocking portion 22 partially overlaps the projection of the underlying conductive layer 21, that is, a projection of a side edge of the blocking portion 22 away from the second portion 202 is located in the projection of the underlying conductive layer 21, and a projection of the side edge of the underlying conductive layer 21 close to the second portion 202 is located in the projection of the blocking portion 22.

In some embodiments, a top surface of the first portion 201 is lower than or flush with a top surface of the second portion 202. The top surface of the first portion 201 being lower than the top surface of the second portion 202 may be an actual design, or may be a case that the two top surfaces are originally designed to be flush with each other, but subsequently, because of a process reason, the top surface of the first portion 201 is actually lower than or flush with the top surface of the second portion 202. For example, the top surface of the first portion 201 and the top surface of the second portion 202 are consecutive surfaces.

In some embodiments, the semiconductor structure is provided with a second isolation layer 261. The second isolation layer 261 is configured to isolate the underlying conductive layer 21 from the transistor in the active region, and is also configured to support the underlying conductive layer 21. The underlying conductive layer 21 may be obtained by etching the second isolation layer 261 to form a groove of a preset pattern, and then filling the groove. In some other embodiments, the second isolation layer includes a first sublayer located below the underlying conductive layer and a second sublayer located in the same layer as the underlying conductive layer. That is, the first sublayer is formed first, then a material is deposited and etched to form the underlying conductive layer 21, and finally gaps in the underlying conductive layer are filled to form the second sublayer. All "isolation layers" mentioned in this application may be composed of multiple sublayers, and may be manufactured by using different process methods. An actual quantity of layers and a manufacturing method of any film layer are not limited in this application.

In some embodiments, the underlying conductive layer 21 further includes an underlying redundant line, and the width and the material of the underlying redundant line are both the same as the width and the material of the underlying signal line, and a difference lies in that the underlying redundant line is not electrically connected to any contact hole. In some other embodiments, the underlying conductive layer further includes an underlying fill line, and the material of the underlying fill line is generally the same as the material of the underlying signal line, but the width of the underlying fill line is less than or equal to the width of the underlying signal line; and the underlying fill line is not electrically connected to any contact hole, and a function of the underlying fill line is to balance densities of conductive materials in different regions so that the underlying conductive layer 21 has a relatively even stress distribution. A manner of forming the underlying fill line and the underlying redundant line may be the same as a manner of forming the underlying signal line.

In some embodiments, the three-dimensional structure 20 is a conductive structure, and projections of the second portion 202 and the underlying conductive layer 21 in the vertical direction Z at least partially overlap. A third isolation layer 262 is further provided in the semiconductor structure, and the third isolation layer 262 is configured to isolate the underlying conductive layer 21 from the three-dimensional structure 20. In some other embodiments, if the projections of the second portion 202 of the three-dimensional structure 20 and the underlying conductive layer 21 in the vertical direction Z do not overlap, or if the bottom surface of the second portion 202 of the three-dimensional structure 20 is made from an insulating material, the third isolation layer 262 may not be provided. All "projections" mentioned in this application are "orthographic projections".

It should be noted that the three-dimensional structure 20 in this application may include multiple complete film layers, may include both a complete film layer and some partial structures of a film layer, or may all be partial structures of a film layer. That is, the material, the quantity of film layers, and integrity of a film layer of three-dimensional structure 20 are not limited in this application.

In some embodiments, a fourth isolation layer 263 is further provided in the semiconductor structure, and the blocking portion 22 is disposed on the fourth isolation layer 263. That is, a top surface of the fourth isolation layer 263 is flush with a bottom surface of the blocking portion 22. The fourth isolation layer 263 is provided in part for the purpose of adjusting the height of the blocking portion 22, and thus adjusting the height of a bottom surface of at least a part of the first portion 201, which helps to avoid occurrence of a recessed portion on a side wall of the first portion 201 facing the contact hole 23, and helps to ensure entire filling of the first isolation layer 265. It should be noted that the fourth isolation layer 263 should not be excessively thick, otherwise the thickness of the three-dimensional structure in the second horizontal direction Y is affected, such that problems such as stress concentration and a weak isolation effect may occur at the bottom of the three-dimensional structure 20. The isolation effect here refers to isolating a conductive material located on opposite sides of the three-dimensional structure 20 in the second horizontal direction Y to avoid problems such as charge leakage and signal interference.

In some embodiments, in the vertical direction Z, the thickness of the fourth isolation layer 263 is 1.5% to 5% of the maximum thickness of the three-dimensional structure 20, such as 2%, 2.5%, 3%, 3.5% or 4.5%.

In some embodiments, a fifth isolation layer 264 is further provided in the semiconductor structure, and the fifth isolation layer 264 is configured to isolate the blocking portion 22 from the three-dimensional structure 20. In some embodiments, if the blocking portion 22 is made from an insulating material or a surface of the three-dimensional structure 20 facing the blocking portion 22 is made from an insulating material, the fifth isolation layer may not be provided. It may be understood that, in the second horizontal direction Y, the fifth isolation layer 264 used for isolation is provided between the blocking portion 22 and the second portion 202, and the fifth isolation layer 264 also plays a blocking role; and thus, in a case in which the fifth isolation layer 264 is provided, only a part of the first portion 201 is located directly above the blocking portion 22, but the first portion 201 is entirely located above the fifth isolation layer 264. "Above" in this application refers to a directly-above position unless otherwise specified.

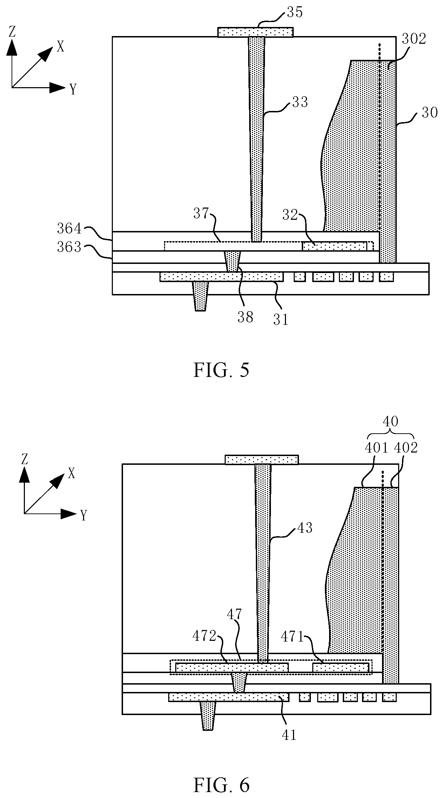

FIG. 5 is a front view of a semiconductor structure according to some embodiments of this application. Referring to FIG. 5, the semiconductor structure further includes a second conductive layer 37 (a range of the second conductive layer 37 is marked by using a dashed box). A blocking portion 32 is a part of the second conductive layer 37, an underlying conductive layer 31 is electrically connected to the second conductive layer 37 through a first conductive plug 38, and the second conductive layer 37 is electrically connected to a first conductive layer 35 through a contact hole 33. In this embodiment, because the second conductive layer 37 is made from a conductive material, a fifth isolation layer 364 may not be provided when a surface of a three-dimensional structure 30 facing the blocking portion 32 is made from an insulating material; otherwise, the fifth isolation layer 364 should be provided. In this embodiment, a fourth isolation layer 363 is provided for the purpose of adjusting a spacing between different conductive layers, which helps to reduce signal crosstalk between different conductive layers.

In the embodiment shown in FIG. 5, although a side edge of the dashed box, which is used to mark the range of the second conductive layer 37, facing a second portion 302 exceeds a side edge of the blocking portion 32 facing the second portion 302, this is only to clearly express that the range of the second conductive layer 37 includes a part of the blocking portion 32. In different embodiments, a side edge of the second conductive layer 37 facing the second portion 302 is flush with the side edge of the blocking portion 32 facing the second portion 302, or may be closer to the second portion 302 than the side edge of the blocking portion 32 facing the second portion 302. Furthermore, in some embodiments, the side edge of the blocking portion 32 facing the second portion 302 is the side edge of the second conductive layer 37 facing the second portion 302.

FIG. 6 is a front view of a semiconductor structure according to some embodiments of this application. Referring to FIG. 6, a three-dimensional structure 40 includes a first portion 401 and a second portion 402, a second conductive layer 47 further includes a signal transmission portion 472, the signal transmission portion 472 and a blocking portion 471 are electrically isolated from each other, the blocking portion 471 is located between the signal transmission portion 472 and the second portion 402, and an underlying conductive layer 41 is electrically connected to a contact hole 43 through the signal transmission portion 472. That is, although the signal transmission portion 472 and the blocking portion 471 belong to the same conductive layer, the signal transmission portion 472 and the blocking portion 471 are different portions that are electrically separated. The blocking portion 471 is not electrically connected to the contact hole 43, and an electrical signal is transmitted between different conductive layers only through the signal transmission portion 472. The signal transmission portion 472 and the blocking portion 471 are set to be separated from each other, which helps to prevent the three-dimensional structure 40 from affecting, through the blocking portion 471, an electrical signal transmitted in the signal transmission portion 472. This effect may be relatively obvious when a potential of the three-dimensional structure 40 changes.

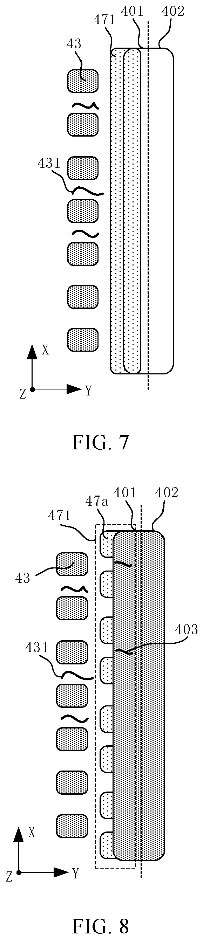

FIG. 7 is a top view corresponding to the semiconductor structure shown in FIG. 6 according to some embodiments of this application. Referring to FIG. 7, the vertical direction Z is perpendicular to a first horizontal direction X, and the semiconductor structure further includes multiple contact holes 43 arranged in the first horizontal direction X and a blocking portion 471 extending in the first horizontal direction X. Each of the contact holes 43 is electrically connected to the underlying conductive layer (not shown in the figure) through a corresponding second signal line in the signal transmission portion 472, and the blocking portion 471 is located between a second signal line corresponding to any of the contact holes 43 and the second portion 402. The blocking portion 471 is provided to extend in the first horizontal direction X, which helps to avoid the occurrence of a first gap in the first horizontal direction X, and thus prevent the first gap from being communicated with a second gap 431 that may exist between adjacent contact holes 43. In this way, it is helpful to avoid or reduce signal crosstalk between different contact holes. It should be noted that the "different contact holes" include adjacent contact holes and non-adjacent contact holes in the first horizontal direction X.

FIG. 8 is a top view corresponding to the semiconductor structure shown in FIG. 6 according to some other embodiments of this application. Referring to FIG. 8, the vertical direction Z is perpendicular to a first horizontal direction X and a second horizontal direction Y, and the first horizontal direction X is perpendicular to the second horizontal direction Y. The semiconductor structure further includes multiple contact holes 43 arranged in the first horizontal direction X, and the blocking portion 471 includes multiple blocking blocks 47a arranged in the first horizontal direction X. In a projection plane perpendicular to the vertical direction Z, the multiple contact holes 43 and the multiple blocking blocks 47a are disposed alternately in the first horizontal direction X and staggered in the second horizontal direction Y. In this way, in a case in which the blocking portion 471 is not an integral structure, but includes multiple blocking blocks that are separated from each other, a first gap 403 formed between adjacent blocking blocks 47a and the second gap 431 located between adjacent contact holes 43 are staggered in the first horizontal direction X. This helps to prevent the first gap 403 and the second gap 431 from being communicated in an expansion procedure, and helps to prevent second gaps 431 at different positions from being communicated through the first gap 403, thereby helping to reduce signal crosstalk between different contact holes 43 caused by filling gaps with a conductive medium. In addition, possible formation regions of the first gap 403 and the second gap 431 are staggered, which helps to avoid a case in which some first gaps 403 are separated and moved in a component manufacturing procedure to cause a gap occurs in a region in which there is originally no second gap 431.

In some other embodiments, in a projection plane perpendicular to the vertical direction, multiple contact holes are aligned with multiple blocking blocks in the first horizontal direction, that is, each of the contact holes has a corresponding blocking block, and the contact hole is aligned with the corresponding blocking block in the first horizontal direction. In this way, the first gap is prevented from being formed between the contact hole and the first portion or the second portion, and stress and support strength of the contact hole are prevented from being affected by the presence of the first gap.

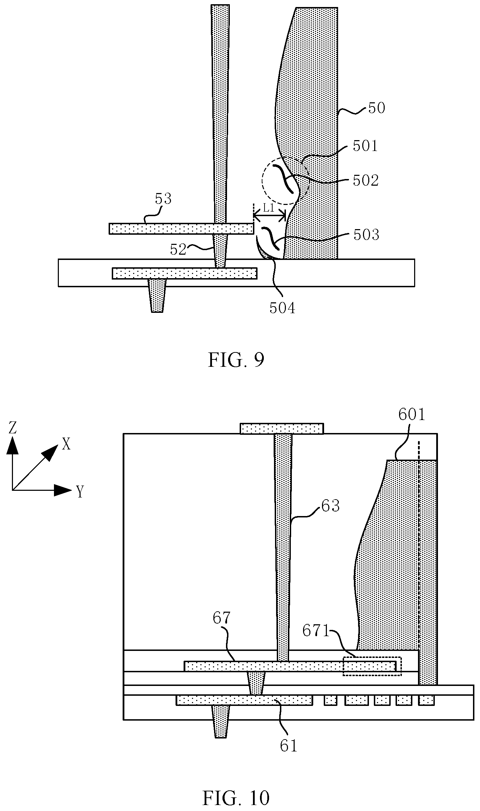

FIG. 9 is a front view of a semiconductor structure. Referring to FIG. 9, in a case in which the semiconductor structure includes a second conductive layer 53 but the second conductive layer 53 does not include a blocking portion, if a distance L1 between the second conductive layer 53 and a three-dimensional structure 50 is within a target range, a third gap 503 may further be formed between the second conductive layer 53 or a first conductive plug 52 and the three-dimensional structure 50 after filling of the material of the isolation layer, and the third gap 503 may be communicated with a first gap 502 in a recessed portion 501 to form a larger gap, thereby affecting strength of a component. In addition, in a procedure of manufacturing the semiconductor structure, even if a design distance between the second conductive layer 53 and the three-dimensional structure 50 is not within the target range, because a part of a portion to be etched 504 that is located between the second conductive layer 55 and the three-dimensional structure 50 is not effectively etched in a procedure of forming the three-dimensional structure 50, the minimum distance between the three-dimensional structure 50 and an adjacent structure is caused to be actually a distance between the three-dimensional structure 50 and the portion to be etched 504. The distance between the three-dimensional structure 50 and the portion to be etched 504 may be less than the design distance and fall within the target range, thereby causing generation of the third gap 503.

FIG. 10 is a front view of a semiconductor structure according to some embodiments of this application. Referring to FIG. 10, a second conductive layer 67 includes multiple second signal lines (not shown in the figure), an underlying conductive layer 61 transmits an electrical signal through the second signal lines and a contact hole 63, the second signal lines extend to below at least a part of a first portion 601, and a blocking portion 671 includes parts of the second signal lines extending to below the first portion 601. A layout in which the signal transmission portion and the blocking portion 671 are separated is no longer provided in the second conductive layer 67. In this way, a formation process of the second conductive layer 67 is simplified, and a deformation resistance capability of the blocking portion 671 is enhanced.

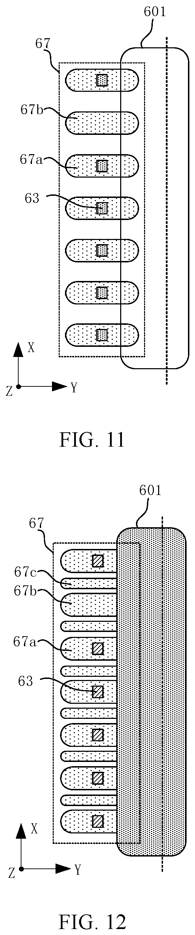

FIG. 11 is a top view corresponding to the semiconductor structure shown in FIG. 10 according to some embodiments of this application. Referring to FIG. 11, the second conductive layer 67 further includes a redundant line 67b, the redundant line 67b is not provided with the contact hole 63, and the blocking portion 671 further includes a part of the redundant line 67b extending to below the first portion 601. A difference between the redundant line 67b and a second signal line 67a is that the second signal line 67a is connected to the contact hole 63 and is configured to transmit an electrical signal, and the redundant line 67b does not have a contact hole 63 correspondingly connected thereto and is not configured to transmit an electrical signal. However, both the second signal line 67a and the redundant line 67b may be connected to the underlying conductive layer through the first conductive plug, and the second signal line 67a and the redundant line 67b generally have the same width. The existence of the redundant line 67b may be used as an alternative to replace a damaged second signal line, or may be a redundancy in layout design, so that the layout design can be applied to different projects. It should be noted that any second signal line that cannot perform a signal transmission function is a damaged second signal line, including but not limited to a second signal line that is disconnected from a signal transmission path of the underlying conductive layer or does not meet a design requirement due to a large resistance. The actual length and width of the second signal line are respectively less than the design length and width.

FIG. 12 is a top view corresponding to the semiconductor structure shown in FIG. 10 according to some embodiments of this application. Referring to FIG. 12, the second conductive layer 67 further includes a fill line 67c, the width of the fill line 67c is less than the width of the second signal line 67a, the fill line 67c is configured to balance densities of conductive materials in different regions of the second conductive layer 67, and the blocking portion 671 further includes a part of the second fill line 67c extending to below the first portion 601. In some embodiments, only the fill line 67c is provided but the redundant line 67b is not provided, or only the redundant line 67b is provided but the fill line 67c is not provided.

In addition, the foregoing "conductive material" refers to the second signal line, or the second signal line and the redundant line, which differs according to whether a redundant line is provided in an embodiment. The fill line 67c may not only be configured to balance the densities of conductive materials in different regions of the second conductive layer 67c, but also be configured to increase the density of a conductive material in a region. For example, in a region in which a second signal line and a redundant line are not provided, the fill line may be made to be extended to below at least a part of the first portion to achieve the function of a blocking portion.

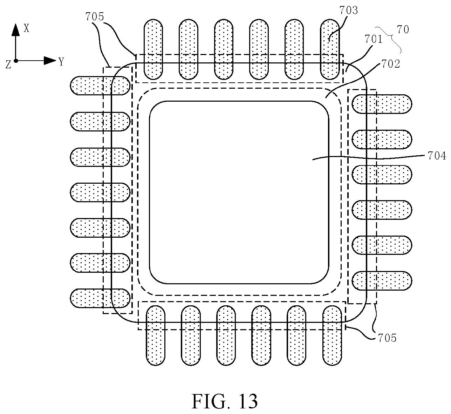

FIG. 13 is a top view of a semiconductor structure according to some embodiments of this application. Referring to FIG. 13, a blocking portion 705 surrounds a three-dimensional structure 70. That the blocking portion 705 surrounds the three-dimensional structure 70 means that the blocking portion 705 is located on at least two sides of the three-dimensional structure 70, and the at least two sides include both two adjacent sides and two opposite sides. The blocking portion 75 on any side of the three-dimensional structure 70 may be an integral continuous structure extending in the same direction as a corresponding part of the three-dimensional structure 70, or may be a separate structure including multiple blocking blocks or including parts of multiple second signal lines extending to below a part of the first portion 701. In addition, if the blocking portion 705 surrounds at least two adjacent sides of the three-dimensional structure 70, the blocking portion 705 located on the two adjacent sides may be an integral continuous structure. In this way, a manufacturing process of the blocking portion is simplified. FIG. 13 is an example in which the blocking portion 705 surrounds the three-dimensional structure 70, and the blocking portion 705 includes at least parts of multiple second signal lines 703 extending into below the first portion 701.

In some embodiments, referring to FIG. 13, the three-dimensional structure 70 is an annular structure. The three-dimensional structure 70 may surround a target structure 704, which is equivalent to that a second portion 702 surrounds the target structure 704; and furthermore, the three-dimensional structure 70 may alternatively cover the top of the target structure 704. The three-dimensional structure 70 may be a functional structure that serves to shield or support the target structure 704, or may be a partial structure that implements a specific function with the target structure 704. In some embodiments, the target structure may be a storage capacitor, and the three-dimensional structure 70 is a top electrode connected to an upper electrode plate of the storage capacitor.

In some embodiments, the three-dimensional structure 70 is a capacitor electrode, and the capacitor electrode includes a top electrode of a storage capacitor or a top electrode or a bottom electrode of a non-storage capacitor. A storage capacitor is a capacitor connected to a storage transistor in a storage unit, and is generally used in a dynamic random access memory, the gate of the storage transistor is connected to a word line, the source thereof is connected to a bit line, and the drain thereof is connected to a storage capacitor.

This application further provides a method for manufacturing a semiconductor structure. Referring to FIG. 1, the method for manufacturing a semiconductor structure includes: forming an underlying conductive layer 24 and a blocking portion 22 sequentially, a plane in which the blocking portion 22 is located being located above a plane in which the underlying conductive layer 24 is located, and projections of the blocking portion 22 and the underlying conductive layer 24 in the vertical direction Z having an overlapping region 212; forming a three-dimensional structure 20, the three-dimensional structure 20 including a first portion 201 and a second portion 202, a top surface of the blocking portion 22 being higher than a bottom surface of the second portion 202 and being lower than or flush with a bottom surface of the first portion 201, and at least a part of the first portion 201 being located directly above the overlapping region 212; forming a first isolation layer 265, the first isolation layer 265 being configured to fill a region above the underlying conductive layer 24 and the blocking portion 22, a top surface of the first isolation layer 265 being higher than a top surface of the three-dimensional structure 20, and the first isolation layer 265 being located on a side of the first portion 201 away from the second portion 202 and covers a side wall of the first portion 201; and forming a contact hole 23 and a first conductive layer 25, the contact hole 23 running through the first isolation layer 265, and the first conductive layer 25 being electrically connected to the underlying conductive layer 24 through the contact hole 23.

It should be noted that forming the underlying conductive layer 24 and the blocking portion 22 sequentially only defines that the underlying conductive layer 24 is formed before the blocking portion 22, and other process steps may exist between a step of forming the underlying conductive layer 24 and a step of forming the blocking portion 22, for example, forming various isolation layers. This is not limited in this application.

A person of ordinary skill in the art may understand that the foregoing implementations are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A semiconductor structure, comprising:
an underlying conductive layer and a blocking portion, a plane in which the blocking portion is located being located above a plane in which the underlying conductive layer is located, and projections of the blocking portion and the underlying conductive layer in a vertical direction having an overlapping region;
a three-dimensional structure, the three-dimensional structure comprising a first portion and a second portion, a top surface of the blocking portion being higher than a bottom surface of the second portion and being lower than or flush with a bottom surface of the first portion, and at least a part of the first portion being located directly above the overlapping region;
a contact hole and a first conductive layer, a plane in which the first conductive layer is located being higher than a top surface of the three-dimensional structure, the contact hole being directly connected to the first conductive layer, the underlying conductive layer being electrically connected to the first conductive layer through the contact hole, and the contact hole being located on a side of the first portion away from the second portion; and
a first isolation layer, the first isolation layer being configured to fill a region between the contact hole and the three-dimensional structure and a region between different contact holes.

2. The semiconductor structure according to claim 1, further comprising: a second conductive layer, the blocking portion being a part of the second conductive layer, the underlying conductive layer being electrically connected to the second conductive layer through a first conductive plug, and the second conductive layer being electrically connected to the first conductive layer through the contact hole.

3. The semiconductor structure according to claim 2, wherein the second conductive layer further comprises a signal transmission portion, the signal transmission portion is separated from the blocking portion, the blocking portion is located between the signal transmission portion and the second portion, and the underlying conductive layer is electrically connected to the contact hole through the signal transmission portion.

4. The semiconductor structure according to claim 3, wherein the vertical direction is perpendicular to a first horizontal direction, and the semiconductor structure further comprises a plurality of contact holes arranged in the first horizontal direction and a blocking portion extending in the first horizontal direction; and each of the contact holes is electrically connected to the underlying conductive layer through a corresponding second signal line in the signal transmission portion, and the blocking portion is located between the second signal line corresponding to any of the contact holes and the second portion.

5. The semiconductor structure according to claim 3, wherein the vertical direction is perpendicular to a first horizontal direction and a second horizontal direction, and the first horizontal direction is perpendicular to the second horizontal direction; the semiconductor structure further comprises a plurality of contact holes arranged in the first horizontal direction, and the blocking portion comprises a plurality of blocking blocks arranged in the first horizontal direction; and in a projection plane perpendicular to the vertical direction, the plurality of contact holes and the plurality of blocking blocks are disposed alternately in the first horizontal direction and staggered in the second horizontal direction.

6. The semiconductor structure according to claim 3, wherein the second conductive layer comprises a plurality of second signal lines, the underlying conductive layer transmits an electrical signal through the second signal lines and the contact hole, the second signal lines extend to below the at least a part of the first portion, and the blocking portion comprises parts of the second signal lines extending to below the first portion.

7. The semiconductor structure according to claim 6, wherein the second conductive layer further comprises a redundant line, the redundant line is not provided with the contact hole, and the blocking portion further comprises a part of the redundant line extending to below the first portion.

8. The semiconductor structure according to claim 6 or 7, wherein the second conductive layer further comprises a second fill line, a width of the second fill line is less than a width of the second signal line, the second fill line is configured to balance densities of conductive materials in different regions of the second conductive layer, and the blocking portion further comprises a part of the second fill line extending to below the first portion.

9. The semiconductor structure according to claim 1, wherein the blocking portion surrounds the three-dimensional structure.

10. The semiconductor structure according to claim 1, wherein the three-dimensional structure is a capacitor electrode, and the capacitor electrode comprises a top electrode of a storage capacitor or a top electrode or a bottom electrode of a non-storage capacitor.

11. A method for manufacturing a semiconductor structure, comprising:
forming an underlying conductive layer and a blocking portion sequentially, a plane in which the blocking portion is located being located above a plane in which the underlying conductive layer is located, and projections of the blocking portion and the underlying conductive layer in a vertical direction having an overlapping region;
forming a three-dimensional structure, the three-dimensional structure comprising a first portion and a second portion, a top surface of the blocking portion being higher than a bottom surface of the second portion and being lower than or flush with a bottom surface of the first portion, and at least a part of the first portion being located directly above the overlapping region;
forming a first isolation layer, the first isolation layer being configured to fill a region above the underlying conductive layer and the blocking portion, a top surface of the first isolation layer being higher than a top surface of the three-dimensional structure, and the first isolation layer being located on a side of the first portion away from the second portion and covers a side wall of the first portion; and
forming a contact hole and a first conductive layer, the contact hole running through the first isolation layer, and the first conductive layer being electrically connected to the underlying conductive layer through the contact hole.
